# EUROPÄISCHE PATENTANMELDUNG

(11) **EP 0 848 451 A2**
(43) Veröffentlichungstag der Anmeldung: **17.06.1998**
(21) Anmeldenummer: 97120601.6
(22) Anmeldetag: 25.11.1997
(51) Int. Cl.: H01R 9/09, H01R 23/68

(54) **Vorrichtung zum elektrischen und mechanischen Verbinden zweier im Abstand zueinander angeordneter Leiterplatten sowie Einrichtung mit zwei in Abstand zueinander angeordneten Leiterplatten, die durch eine derartige Vorrichtung verbunden sind**

(30) Priorität: 10.12.1996 DE 19651187
(71) Anmelder: Mannesmann VDO Aktiengesellschaft, 60388 Frankfurt/M. (DE)
(72) Erfinder: Barz, Herbert, 65439 Flörsheim/Main (DE)
(74) Vertreter: Rassler, Andrea, Dipl.-Phys.

(57) **Zusammenfassung**

Bei einer Vorrichtung zur elektrischen und mechanischen Verbindung zweier im Abstand zueinander angeordneter Leiterplatten (3, 4), insbesondere eines Hybridmoduls mit einer Grundträgerleiterplatte, wobei die Vorrichtung elektrisch leitende Verbindungselemente (1) aufweist, an deren einem Endbereich ein Lötstift (11) ausgebildet ist, ist vorgesehen, daß an dem anderen Endbereich der Verbindungselemente (1) eine Lötzunge (14) ausgebildet ist, daß die Verbindungselemente (1) zwischen der Lötzunge (14) und dem Lötstift (11) einen elastischen Bereich aufweisen, und daß eine Mehrzahl der Verbindungselemente (1) von einem gemeinsamen Isolierkörper (20) gehalten wird.

## Beschreibung

Die Erfindung betrifft eine Vorrichtung zum elektrischen und mechanischen Verbinden zweier im Abstand zueinander angeordneter Leiterplatten, insbesondere eines Hybridmoduls mit einer Grundträgerleiterplatte, wobei die Vorrichtung Verbindungselemente mit jeweils einem Lötstift aufweist, sowie eine Einrichtung mit zwei im Abstand zueinander angeordneten Leiterplatten, die durch eine derartige Vorrichtung verbunden sind.

Aus dem Stand der Technik ist es bekannt, zur Verbindung zweier Leiterplatten Anschlußkämme zu verwenden. Hierbei sind die Anschlußkämme aus einer Anzahl von einzelnen Kontaktelementen aufgebaut, die klammerartig die Seitenkanten einer ersten Leiterplatte umgreifen und weiterhin mit ihren Lötstiften mit einer zweiten Leiterplatte z.B. durch Wellenlötung elektrisch und mechanisch verbunden sind. Nachteilig hierbei ist es, daß die Anschlußkämme bei einer hohen Anzahl von benötigten elektrischen Verbindungen (z.B. größer als 40) die Mindestgröße der Modulplatte vorgeben, damit alle Anschlüsse untergebracht werden können.

Aufgabe der Erfindung ist es daher, eine Vorrichtung zur Verbindung zweier Leiterplatten und eine Einrichtung mit einer derartigen Vorrichtung anzugeben, die weniger Platz beansprucht und so die Leiterplattengröße nicht von der benötigten Anzahl der Verbindungen abhängig macht.

Diese Aufgabe wird durch eine Vorrichtung gelöst, die Verbindungselemente mit einem Lötstift und einer Lötzunge aufweist, wobei zwischen der Lötzunge und dem Lötstift ein elastischer Bereich vorhanden ist und die Verbindungselemente von einem gemeinsamen Isolierkörper gehalten werden.

Hierbei ist es vorteilhaft, daß die Lötzungen gleichzeitig mit sonstigen oberflächenmontierbaren Bauteilen befestigt werden können und so auf einen zusätzlichen Lötprozeß, wie er ansonsten bei den Anschlußkämmen erforderlich ist, verzichtet werden kann. Weiterhin wird durch die Verwendung des Isolierkörpers die mechanische Stabilität der Verbindung erhöht und die Montierbarkeit weiter vereinfacht, da zur Verbindung der zwei Leiterplatten nur noch ein einziges Bauteil benötigt wird.

Vorteilhafte Ausgestaltungen der Erfindungen sind in Unteransprüchen und der folgenden Beschreibung zu entnehmen. Dadurch, daß die Lötzungen derart seitlich von dem Isolierkörper weg ragen, daß sie bei Aufsicht auf den Isolierkörper einsehbar sind, können die Lötstellen der Lötzungen auf der Leiterplatte optisch kontrolliert werden, so daß auf eine aufwendige elektrische Überprüfung der einzelnen Verbindungen verzichtet werden kann.

Durch die Ausgestaltung des Isolierkörpers als Rahmen wird eine Bauform erreicht, die Platz für eine große Anzahl von Verbindungselementen bietet und gleichzeitig eine mechanische Stabilität erreicht, insbesondere wenn der Rahmen in etwa die Abmessungen der Leiterplatte aufweist, auf der die Lötzungen der Verbindungselemente befestigt werden. Der Rahmen kann eine rechteckige, quadratische oder auch eine ovale, runde oder mehreckige Form aufweisen.

Bei einer Anordnung der Lötzungen derart, daß sie bei einer Aufsicht auf den Rahmen in das Innere des Rahmens zeigen, ist es vorteilhaft, daß der Rahmen von der Zange eines automatischen Bestückungssystems ergriffen werden kann, ohne daß die Gefahr des Verbiegens der Verbindungselemente besteht.

Eine Anordnung der Lötzungen derart, daß sie bei Aufsicht auf den Rahmen außerhalb des Rahmens angeordnet sind, hat den Vorteil, daß der Platz auf der ersten Leiterplatte optimal genutzt werden kann und damit auch eine bessere Entflechtung der Schaltung auf der ersten Leiterplatte möglich ist.

Durch Verwendung von Positionierhilfen für die Montage der Vorrichtung auf der ersten und/oder zweiten Leiterplatte wird eine einfache Montage erreicht und eine automatische Montierbarkeit weiter verbessert.

Sofern die Positionierhilfe als Verdrehschutz ausgestaltet ist, ist eine seitenverkehrte Montage ausgeschlossen.

Durch die Verwendung einer Rastnase ist eine einfache dauerhafte Montage der Verbindungselemente in einem vorher hergestellten Isolierkörper, der Aufnahmetaschen für die Rastnasen aufweist, möglich. Es ist auch möglich, die Verbindungselemente mit dem Isolierkörpermaterial zu umgeben und dann in die endgültige Form zu bringen, z.B. durch Spritzguß. Diese Vorgehensweise ist aber insgesamt aufwendiger.

Durch die Ausgestaltung des elastischen Bereichs derart, daß zwischen den Lötzungen und dem Zwischenbereich ein schmaler Bereich vorhanden ist, der mit dem Zwischenbereich einen Winkel von vorzugsweise 90° einschließt, wird diese in einfach herstellbarer Weise realisiert. Da die Bereiche verschiedene Breiten aufweisen, kann der schmale Bereich bei einer Belastung senkrecht zu den Lötflächen der Lötzungen gut nachgeben, wie diese z.B. infolge von Verbiegungen durch die unterschiedlichen Wärmeausdehnungen der durch die Vorrichtung verbundenen Leiterplatten verursacht wird.

Durch die Ausgestaltung des schmalen Bereichs des Verbindungselementes mit zwei gegensinnigen Biegungen, die jeweils einen stumpfen Winkel einschließen, wird eine einfach herstellbare und dauerhafte Elastizität auch parallel zur Lötfläche der Lötzunge realisiert.

Durch Einfügung einer durchgehenden Öffnung in die Lötzungen wird erreicht, daß sich bei dem Aufsetzen der Lötzungen auf die mit Lötpaste bedruckten Anschlußstellen die Lötpaste nicht zur Seite, sondern in die durchgehende Öffnung gedrückt wird und so eine gute elektrische und mechanische Verbindung gewährleistet ist, ohne daß die Gefahr besteht, daß überschüssiges Lot zu Kurzschlüssen mit den benachbarten Lötstellen führt.

Durch die Ausgestaltung des Verbindungselements als verzinntes Kupferblechstanzteil ist eine kostengünstige Herstellung und Montage in den Isolierkörper möglich.

Mit der erfindungsgemäßen Vorrichtung ist es möglich, eine Einrichtung mit zwei im Abstand zueinander angeordneten Leiterplatten anzugeben, bei der die Vorrichtung mit einer ersten Leiterplatte durch Oberflächenmontage elektrisch und mechanisch verbunden ist und bei der die Vorrichtung mit einer zweiten Leiterplatte durch Durchsteckmontage elektrisch und mechanisch verbunden ist.

Die Erfindung wird nachfolgend für besonders bevorzugte Ausführungsbeispiele anhand der Figuren näher erläutert:

Es zeigen:
- Figur 1:: Die Ansichten eines besonders bevorzugten Verbindungselements.
- Figur 2:: Den Teilausschnitt durch einen besonders bevorzugten Isolierkörper mit einem eingesetzten Verbindungselement aus Figur 1.
- Figur 3:: Den Teilschnitt einer besonders bevorzugten Vorrichtung zwischen zwei zu verbindenden Leiterplatten.
- Figur 4:: Die Aufsicht auf eine bevorzugte Vorrichtung in Rahmenform.
- Figur 5:: Die Aufsicht auf eine weitere bevorzugte Vorrichtung in Rahmenform, die auf eine erste Leiterplatte montiert ist.

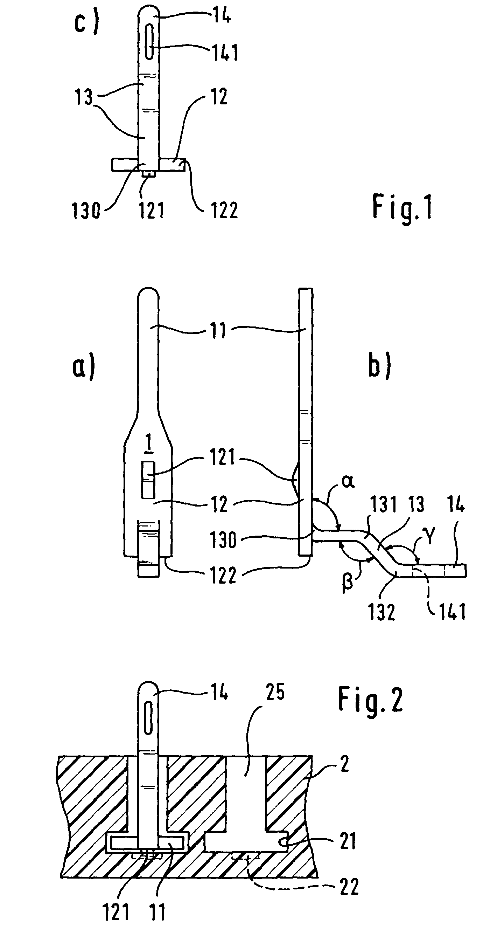

In Figur 1 ist die Vorderansicht eines besonders bevorzugten erfindungsgemäßen Verbindungselements 1 mit a), die entsprechende Seitenansicht mit b) und die entsprechende Ansicht von unten c) bezeichnet. Das Verbindungselement 1 ist vorteilhafterweise als Stanzbiegeteil aus verzinntem Kupferblech ausgeführt und weist einen Lötstift 11, einen schmalen Bereich 13 und eine Lötzunge 14 auf. Vorteilhafterweise ist zwischen dem schmalen Bereich 13 und dem Lötstift 11 ein Zwischenbereich 12 mit Rastnase 121 eingeordnet. Der schmale Bereich 13 schließt mit dem Zwischenbereich 12 einen Winkel α von etwa 90° ein. Die dazu erforderliche Biegung 130 weist vorteilhafterweise bereits die Breite des schmalen Bereichs 13 auf. Der schmale Bereich 13 weist weiterhin zwei Biegungen 131, 132 auf, die die stumpfen Winkel β, γ einschließen. Sofern der Winkel α zwischen dem Zwischenbereich 12 und dem schmalen Bereich 13 90° beträgt, sind die Winkel β, γ gleich, da der Zwischenbereich 12 und der Lötstift 11 vorteilhafter senkrecht zu den zu verbindenden Leiterplatten stehen.

In Figur 2 ist ein Verbindungselement 1 aus Figur 1 in einem Teilausschnitt eines besonders bevorzugten Isolierkörpers 2 dargestellt. Der Isolierkörper 2 weist eine Führungsnut 21 und eine Aufnahmetasche 22 auf. Die Führungsnut 22 führt das Verbindungselement 1 im Bereich des Zwischenbereichs 12. Dabei ist die Rastnase 121 in der Aufnahmetasche 22 eingerastet und verhindert, daß sich das Verbindungselement 1 aus der Führungsnut 21 entfernen kann. Der Zwischenraum 25 des Isolierkörpers 2 ist für die Funktion der erfindungsgemäßen Vorrichtung nicht erforderlich, vereinfacht aber die Herstellung des Isolierkörpers 2 und spart weiterhin Material ein.

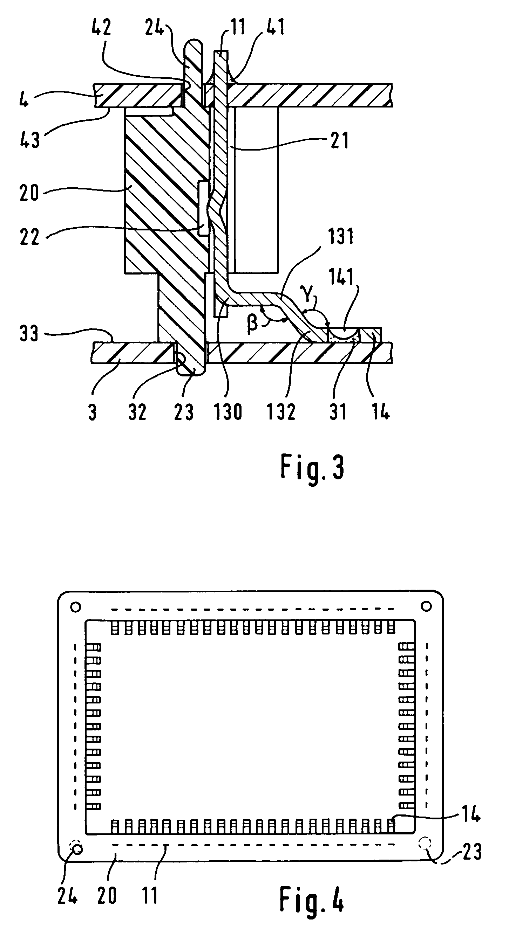

Figur 3 zeigt den Teilschnitt einer erfindungsgemäßen Vorrichtung zwischen zwei zu verbindenden Leiterplatten 3, 4. Der Rahmen 20 weist zusätzlich Positionierhilfen 23, 24 auf, die in entsprechende Ausnehmungen 32, 42 der Leiterplatten 3, 4 eingreifen und so die exakte Lage des Rahmens 20 auf den Leiterplatten 3, 4 bestimmen. Vorteilhafterweise sind die Verbindungen derart hergestellt, daß zunächst die Oberseite 33 der Leiterplatte 3 mit Reflowlötpaste bedruckt wird, dann die nicht dargestellten auf die Oberseite 33 zu montierenden Bauelemente aufgesetzt und schließlich der Rahmen 20 mit den zuvor eingesetzten Verbindungselementen 1 aufgesetzt wird und dann in einem Arbeitsgang die Bauelemente und Lötzungen 14 der Verbindungselemente 1 durch Reflowlöten elektrisch und mechanisch mit den nicht dargestellten elektrischen Anschlußleitungen der Leiterplatte 3 verbunden werden. In der durchgehenden Öffnung 141 kann sich überflüssiges Lot der Lötstelle 31 sammeln, so daß die Lötstelle nicht mit den benachbarten Lötstellen kurzgeschlossen wird. Danach kann eine optische Kontrolle der Lötstellen 31 ohne besonderen Aufwand durchgeführt werden.

Anschließend kann der Rahmen mit den Positionierhilfen 24 auf die Oberseite der Leiterplatte 4 aufgesetzt werden und die Lötstifte 11 vorzugsweise in einem Wellenlötbad mit der Leiterplatte 4 elektrisch und mechanisch mittels der Lötstellen 41 verbunden werden. Dabei können gleichzeitig die sonstigen durch die Montage auf der Oberseite 43 der Leiterplatte 4 zu montierenden Bauelemente gelötet werden. Auch hierbei ist eine optische Kontrolle der Lötstellen 41 nach der Lötung möglich.

Durch die vorbeschriebenen Biegungen 130, 131, 132 wird eine derartige Elastizität erreicht, daß ein Abreißen der Lötzungen 14 von den Lötstellen 31 auch bei einem Verbiegen der Leiterplatte 3 infolge der unterschiedlichen Wärmeausdehnungen der Leiterplatten 3, 4 verhindert wird.

Bei der Aufsicht auf die erfindungsgemäß besonders bevorzugte Vorrichtung in Figur 4 erkennt man den als Rahmen 20 ausgestalteten Isolierkörper 2, unter dem die Lötzungen 14 in das Innere des Rahmens 20 ragen. So sind die Lötstellen der überstehenden Lötzungen 14 leicht optisch zu kontrollieren. Der Rahmen weist auf seiner Oberseite drei Positionierhilfen 24 und auf seiner Unterseite zwei Positionierhilfen 23 auf. Durch die dargestellte Anordnung der Positionierhilfen ist ein versehentliches Verdrehen der Leiterplatten 3,4 gegeneinander ausgeschlossen. Der Rahmen 20 hat vorteilhafterweise etwa die gleichen Außenabmessungen wie die erste Leiterplatte 3, mit der er durch Oberflächenmontage (Reflowlötung) verbunden wird. Dadurch wird eine besonders stabile und leicht montierbare Verbindung der Leiterplatten 3, 4 realisiert. Bei der Auswahl eines geeigneten Materials für die Isolierkörper 2, insbesondere eines Kunststoffs, ist vor allem darauf zu achten, daß der Isolierkörper die erforderliche Reflowlötung ohne Verformung übersteht.

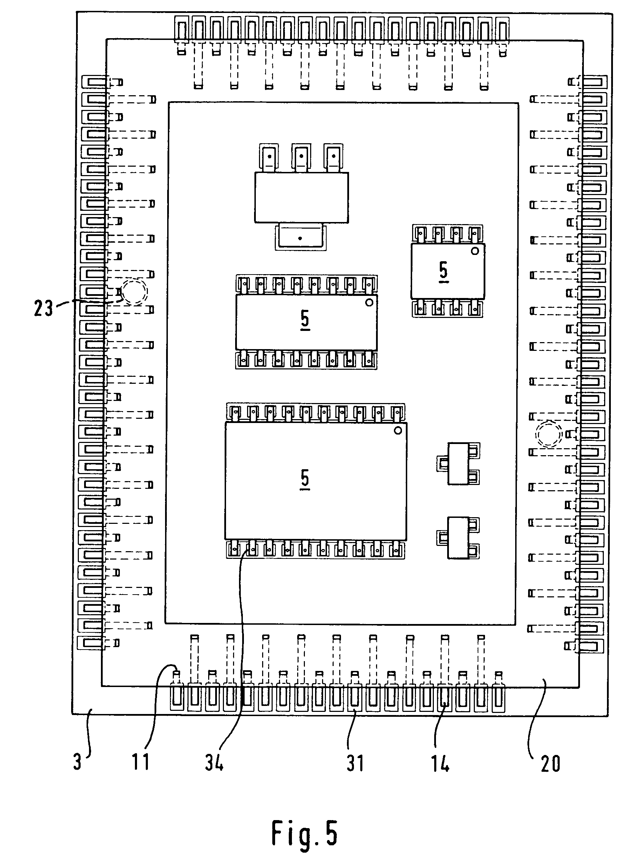

Bei der Aufsicht auf eine weitere bevorzugte Vorrichtung in Figur 5 erkennt man, daß die Lötzungen 14 alle nach außerhalb des Rahmens 20 zeigen und die Lötstellen 31 auf der ersten Leiterplatte 3 ebenfalls von oben optisch überprüft werden können. Durch diese Ausgestaltung ist auch eine Bestückung mehrerer Leiterplatten 3 im Nutzen mit Rahmen 20 und elektronischen Bauteilen 5 und anschließendem Reflowlöten der Lötstellen 34, 31 aller auf die Leiterplatte 3 zu montierenden Bauteile 5, 20 möglich und eine optimale Ausnutzung des Platzes auf der ersten Leiterplatte 3 möglich. Selbstverständlich ist es auch möglich, die Lötzungen 14 sowohl innerhalb als auch außerhalb eines einzigen Rahmens 20 anzuordnen.

## Patentansprüche

1. Vorrichtung zur elektrischen und mechanischen Verbindung zweier im Abstand zueinander angeordneter Leiterplatten (3, 4), insbesondere eines Hybridmoduls mit einer Grundträgerleiterplatte, wobei die Vorrichtung elektrisch leitende Verbindungselemente (1) aufweist, an deren einem Endbereich ein Lötstift (11) ausgebildet ist, dadurch gekennzeichnet, daß an dem anderen Endbereich der Verbindungselemente (1) eine Lötzunge (14) ausgebildet ist, daß die Verbindungselemente (1) zwischen der Lötzunge (14) und dem Lötstift (11) einen elastischen Bereich aufweisen, und daß eine Mehrzahl der Verbindungselemente (1) von einem gemeinsamen Isolierkörper (2) gehalten wird.

2. Vorrichtung nach Anspruch 1, dadurch gekennzeichnet, daß die Lötzungen (14) derart seitlich von dem Isolierkörper (2) weg ragen, daß sie bei Aufsicht auf den Isolierkörper (2) einsehbar sind.

3. Vorrichtung nach Anspruch 1 oder 2, dadurch gekennzeichnet, daß der Isolierkörper (2) als Rahmen (20) gestaltet ist.

4. Vorrichtung nach Anspruch 3, dadurch gekennzeichnet, daß die Lötzungen (14) so angeordnet sind, daß sie bei einer Aufsicht auf den Rahmen (20) in das Innere des Rahmens (20) zeigen.

5. Vorrichtung nach Anspruch 3, dadurch gekennzeichnet, daß die Lötzungen (14) so angeordnet sind, daß sie bei einer Aufsicht auf den Rahmen (20) nach außerhalb des Rahmens (20) zeigen.

6. Vorrichtung nach einem der vorstehenden Ansprüche, dadurch gekennzeichnet, daß der Isolierkörper (2) Positionierhilfen (23, 24) für die Montage der Vorrichtung auf der ersten und/oder der zweiten Leiterplatte (3, 4) aufweist.

7. Vorrichtung nach Anspruch 6, dadurch gekennzeichnet, daß die Positionierhilfen (23, 24) zusätzlich als Verdrehschutz ausgestaltet sind.

8. Vorrichtung nach Anspruch 6 oder 7, dadurch gekennzeichnet, daß die Positionierhilfen (23, 24) als Positionierstifte ausgestaltet sind, die in entsprechende Ausnehmungen (32, 42) der ersten und/oder zweiten Leiterplatte (3, 4) einführbar sind.

9. Vorrichtung nach einem der vorstehenden Ansprüche, dadurch gekennzeichnet, daß die Verbindungselemente (1) einen Zwischenbereich (12) aufweisen, mit dem sie von dem Isolierkörper (2) gehalten werden.

10. Vorrichtung nach Anspruch 9, dadurch gekennzeichnet, daß der elastische Bereich zwischen den Lötzungen (14) und dem Zwischenbereich (12) angeordnet ist.

11. Vorrichtung nach Anspruch 9 oder 10, dadurch gekennzeichnet, daß die Verbindungselemente (1) im Zwischenbereich (12) eine Rastnase (121) aufweisen, die in eine Aufnahmetasche (22) des Isolierkörpers (2) einrastbar ist.

12. Vorrichtung nach Anspruch 10 oder 11, dadurch gekennzeichnet, daß der elastische Bereich dadurch realisiert wird, daß der elastische Bereich ein schmaler Bereich (13) des Verbindungselements (1) ist, der mit dem Zwischenbereich einen Winkel (α) von vorzugsweise 90° einschließt.

13. Vorrichtung nach Anspruch 12, dadurch gekennzeichnet, daß der schmale Bereich (13) zwei gegensinnige Biegungen (131, 132) aufweist, die jeweils einen stumpfen Winkel (β, γ) einschließen.

14. Vorrichtung nach einem der vorstehenden Ansprüche, dadurch gekennzeichnet, daß die Lötzungen (14) jeweils eine durchgehende Öffnung (141) aufweisen.

15. Vorrichtung nach einem der vorstehenden Ansprüche, dadurch gekennzeichnet, daß das Verbindungselement (1) als Blechstanzteil aus vorzugsweise verzinntem Kupferblech hergestellt ist.

16. Einrichtung mit zwei im Abstand zueinander angeordneten Leiterplatten (3, 4), dadurch gekennzeichnet, daß die Leiterplatten (3, 4) durch eine Vorrichtung nach einem der vorstehenden Ansprüche elektrisch und mechanisch verbunden sind.

17. Einrichtung nach Anspruch 16, dadurch gekennzeichnet, daß die Vorrichtung mit der ersten Leiterplatte (3) durch Oberflächenmontage der Lötzungen (14) elektrisch und mechanisch verbunden ist und daß die Vorrichtung mit der zweiten Leiterplatte (4) durch Durchsteckmontage der Lötstifte (11) elektrisch und mechanisch verbunden ist.
